(19) Europäisches Patentamt
European Patent Office
Office européen des brevets

(11) EP 4 770 336 A1

(12) EUROPEAN PATENT APPLICATION

(43) Date of publication:
01.07.2026 Bulletin 2026/27

(51) International Patent Classification (IPC):
H10D 89/60 (2025.01)   H02H 9/04 (2006.01)

(21) Application number: 25216413.2

(52) Cooperative Patent Classification (CPC):
H10D 89/921

(22) Date of filing: 17.11.2025

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 31.12.2024 US 202419006315

(71) Applicant: NXP B.V.
5656 AG Eindhoven (NL)

(72) Inventor: Quax, Guido Wouter Willem
5656 AG Eindhoven (NL)

(74) Representative: Schmütz, Christian Klaus
Johannes
NXP Semiconductors Germany GmbH
Intellectual Property Group
Beiersdorfstr. 12
22529 Hamburg (DE)

(54) LOW-LEAKAGE ESD RAIL CIRCUITS AND METHODS

(57) Circuits and methods are disclosed that include a boost rail having a first voltage and an electrostatic discharge (ESD) rail having a second voltage that is less than the first voltage. An ESD protection circuit may include a trigger circuit configured to determine an ESD event on the boost rail and to selectively activate a clamp circuit to shunt current from the ESD rail to a power supply terminal in response to the ESD event. The circuit may include a first voltage drop circuit having a first configuration and coupled between a first power supply terminal and the boost rail to provide the first voltage and a second voltage drop circuit having a second configuration and coupled between the ESD rail and one of the boost rail or the first power supply terminal.

FIG. 1

## Description

FIELD OF USE

The present disclosure generally relates to electrostatic discharge (ESD) circuits, and more particularly, to low-leakage ESD rail circuits.

BACKGROUND

Rail clamp circuits that are commonly used for electrostatic discharge (ESD) protection may include a trigger circuit coupled to a control terminal of a large metal-oxide semiconductor field-effect transistor (MOSFET), which is configured to activate and shunt the ESD current to ground in response to an ESD event. Such MOSFETs (typically n-channel MOSFETs (NMOS) devices) may need to be relatively large to be able to shunt the current. As a result, the leakage currents from the rail clamp circuits can be large, adversely impacting the overall power consumption of the circuit.

BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.

FIG. 1 depicts a partial block and partial circuit diagram of a first embodiment of a circuit including a low-leakage ESD protection circuit using a boost rail and an ESD rail having a voltage related to a supply voltage.

FIG. 2A depicts a circuit diagram of a transistor-based voltage drop element that may be used in the circuit of FIG. 1 to provide a voltage drop between the supply voltage and one or more of the boost rail and the ESD rail, in accordance with certain embodiments.

FIG. 2B depicts a circuit diagram of a diode-based voltage drop element that may be used in the circuit of FIG. 1, in accordance with certain embodiments.

FIG. 2C depicts a circuit diagram of a resistor-based voltage drop element that may be used in the circuit of FIG. 1, in accordance with certain embodiments.

FIG. 2D depicts a circuit diagram of a transistor-based voltage drop element including two transistors in series with a shared deep n-well and with a common gate voltage that may be used in the circuit of FIG. 1, in accordance with certain embodiments.

FIG. 2E depicts a circuit diagram of a transistor-based voltage drop element including two transistors in series with a shared deep n-well that may be used in the circuit of FIG. 1, in accordance with certain embodiments.

FIG. 3A depicts a circuit diagram of a transistor-based voltage drop element including two transistors in series with separate deep n-wells that may be used in the circuit of FIG. 1, in accordance with certain embodiments.

FIG. 3B depicts a circuit diagram of a diode-based voltage drop element including multiple diodes in series that may be used in the circuit of FIG. 1, in accordance with certain embodiments.

FIG. 3C depicts a circuit diagram of a resistor-based voltage drop element including multiple diodes in series that may be used in the circuit of FIG. 1, in accordance with certain embodiments.

FIG. 4 depicts a partial block and partial circuit diagram of a circuit including a low-leakage ESD protection circuit using a boost rail and an ESD rail having a voltage related to a supply voltage, in accordance with certain embodiments.

FIG. 5 depicts a partial block and partial circuit diagram of a second embodiment of circuit including a low-leakage ESD protection circuit using a boost rail and an ESD rail having a voltage related to a supply voltage.

FIG. 6 depicts a method of providing ESD protection using a low-leakage ESD protection circuit with a boost rail and an ESD rail, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

DETAILED DESCRIPTION

Embodiments of circuits and methods are described below that include an ESD protection circuit configured reduce the leakage in ESD rail-clamp networks by using a separate boost rail and a separate ESD rail. In one or more embodiments, the ESD protection circuit may include a large metal-oxide semiconductor field-effect transistor (MOSFET) including a first terminal coupled to the ESD rail, a control terminal, and a second terminal coupled to ground. The ESD protection circuit may include a trigger circuit coupled to the boost rail and a second terminal coupled to the control terminal of the MOSFET. In one or more embodiments, the circuit may apply a first voltage to the boost rail and a second voltage to the ESD rail where the first voltage is greater than the second voltage. The lower second voltage on the ESD rail yields a lower leakage current from the large MOSFET than in conventional ESD protection circuits. In one or more embodiments, the MOSFET may be implemented as an NMOS device. Since the boost rail carries a voltage that is greater than the ESD rail, the gate of the NMOS device can drive the gate of the NMOS, while the drain of the NMOS is coupled to the ESD rail to shut the current. An advantage realized by this configuration is that the voltage drop across the metal tracks of the ESD rail is not present for the boost rail, such that the gate of the NMOS can be pulled up higher than the drain, allowing the NMOS to shunt more current.

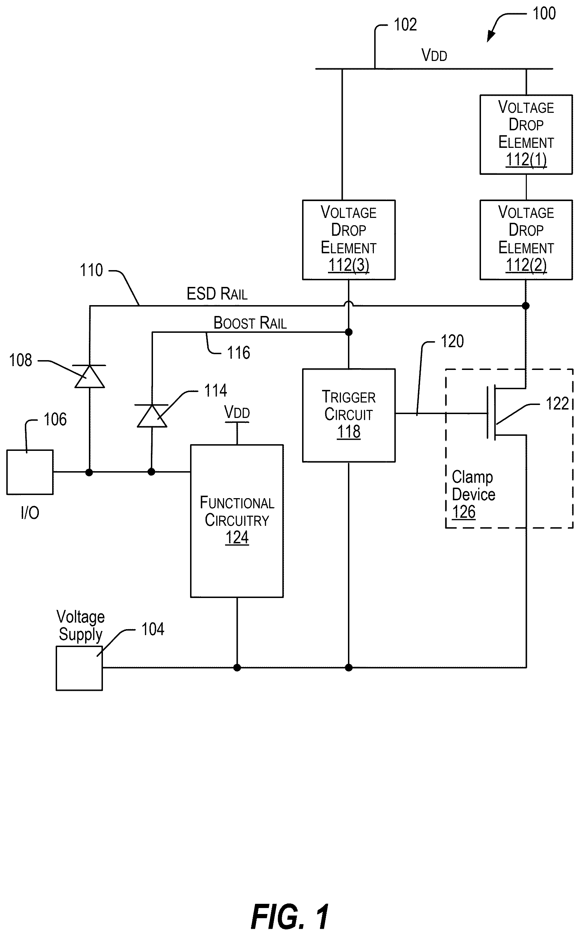

In one or more embodiments, one or more of the boost rail and the ESD rail are time-varying in the sense that their respective voltages vary with leakage current through the transistor. In one or more embodiments, the leakage current may vary with circuit temperature variations, causing the voltage levels on one or more of the boost rail and the ESD rail to vary (or float) relative to the supply voltage. In one or more embodiments, a first biasing scheme (or circuit) may be used to bias the floating boost rail and a second biasing scheme (or circuit) may be used to bias the floating ESD rail at a lower voltage than the boost rail. An illustrative, nonlimiting example of a circuit including an ESD protection circuit that includes a boost rail and an ESD rail is described below with respect to FIG. 1.

FIG. 1 depicts a partial block and partial circuit diagram of a first embodiment of a circuit 100 including a low-leakage ESD protection circuit using a boost rail 116 and an ESD rail 110 having a voltage related to a supply voltage $V_{DD}$ at terminal 102. The circuit 100 may be coupled to a second supply voltage $V_{SS}$ 104, which may be a voltage supply rail that could be at ground, a negative voltage, or another selected voltage level. In one or more embodiments, the second supply voltage terminal 104 may correspond to a circuit package ground connection or may be coupled to a local supply voltage. In one or more embodiments, the second supply voltage terminal 104 may be coupled to a ground connection of the microelectronics package or may be second supply voltage, which may be different from the supply voltage $V_{DD}$ at terminal 102.

The circuit 100 may include a conductive trace (sometimes referred to as an "input/output (I/O) terminal" 106, which may be configured to couple to another circuit or to receive a signal. In one or more embodiments, the I/O terminal 106 may be an integrated circuit terminal pad, a package pad, a post, a bump, a pad, or another conductive element that may be configured to establish an electrical connection. In the illustrated example of FIG. 1, though only one I/O terminal 106 is shown, it should be appreciated that multiple I/O terminals may be included and that I/O terminals may be coupled to either of the boost rail 116 or the ESD rail 110.

The circuit 100 may include a diode 108 including an anode coupled to the I/O terminal 106 and a cathode coupled to the ESD rail 110. The circuit 100 may include a diode 114 including an anode coupled to the I/O terminal 106 and a cathode coupled to the boost rail 116. The circuit 100 may also include functional circuitry 124 coupled to the contact pad 106. The functional circuitry 124 may include processing logic or other circuitry configured to receive signals from the I/O terminal 106 and to perform one or more operations on the received signals.

The ESD rail 110 may be biased relative to one or more of the boost rail 116 or the supply voltage $V_{DD}$ at terminal 102 by one or more voltage drop elements 112. Each voltage drop element 112 may be configured to decrease a current level as current flows through the voltage drop element 112. Each voltage drop element 112 may include one or more circuit elements, such as a resistor, a diode, or a MOSFET, any of which may cause a voltage to decrease as current flows from a first terminal to a second terminal across the device. In a diode, for example, the amount of voltage drop may be determined by its threshold voltage. In a resistor, the amount of voltage drop may be a function of the amount of current flowing across the resistor, and so on. In or more embodiments, a first voltage on the boost rail 116 and a second voltage on the ESD rail 110 may be floating, meaning that the boost rail 116 and the ESD rail 110 are nets that have voltage potentials that are at least partially defined by leakage currents, which may vary with temperature and based on one or more other factors.

In the illustrated example, the circuit 100 may include a first voltage drop element 112(1) including a first terminal coupled to the supply voltage $V_{DD}$ at terminal 102 and including a second terminal. The circuit 100 may include a second voltage drop element 112(2) including a first terminal coupled to the second terminal of the first voltage drop element 112(1) and including a second terminal coupled to the ESD rail 110.

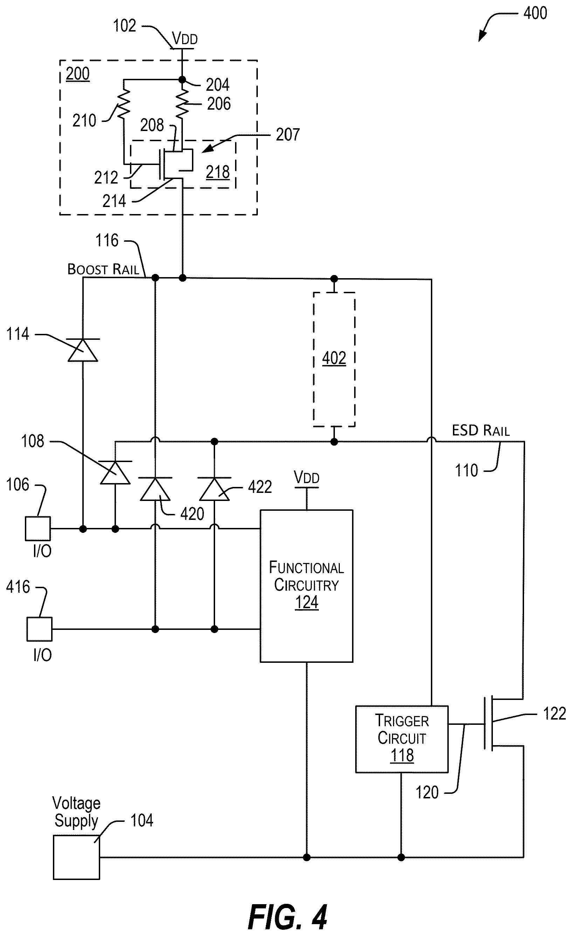

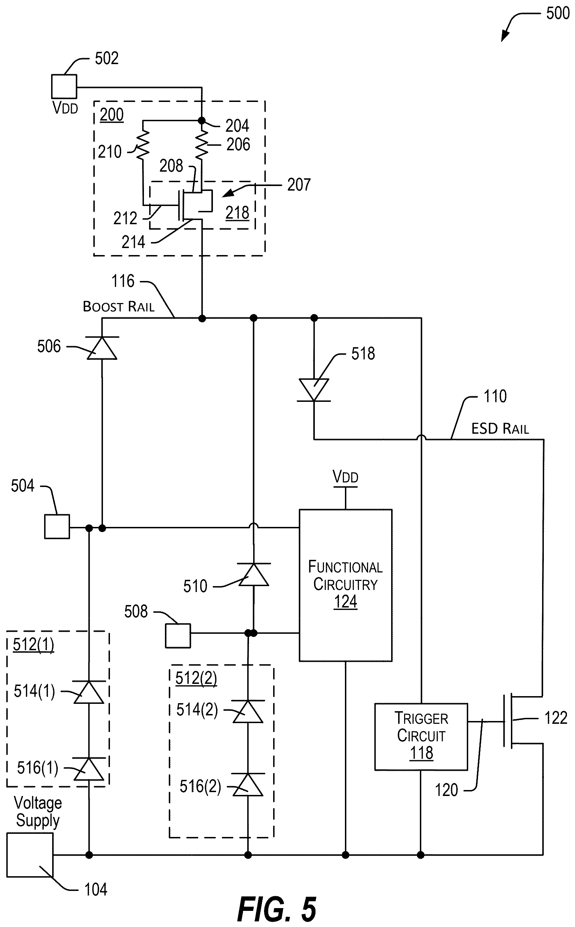

The boost rail 116 may be biased relative to the supply voltage $V_{DD}$ at terminal 102 by one or more voltage drop elements 112, such as the voltage drop element 112(3). In the illustrated example, the voltage drop element 112(3) may include a first terminal coupled to the supply voltage VDD at terminal 102 and a second terminal coupled to the boost rail 116. In this configuration, the boost rail 116 and the ESD rail 110 may have voltage levels that differ from one another and that may be based on but may vary relative to the supply voltage $V_{DD}$ at terminal 102 due to leakage currents. In one or more alternative embodiments (such as those depicted in FIGs. 4 and 5), the voltage levels on the boost rail 116 and the ESD rail 110 may differ from one another and may vary relative to the supply voltage $V_{DD}$ at the terminal 102 due to leakage currents and relative to one another.

The circuit 100 may include a trigger circuit 118 including a first terminal coupled to the boost rail 116, a second terminal coupled to ground 104, and a third terminal. The circuit 100 may include a clamp device 126 including a first terminal coupled to the ESD rail 110, a control terminal 120 coupled to the third terminal of the trigger circuit 118, and a second terminal coupled to second supply voltage terminal 104. The clamp device 126 may be implemented using various circuit elements or combinations of circuit elements. In the illustrated example, the clamp device 126 is depicted as including a single MOS transistor device 122. In one or more embodiments, the clamp device 126 may include multiple MOS transistor devices 122, other circuitry, or any combination thereof.

In one or more embodiments, the trigger circuit 118 may be configured to monitor a voltage level or current level on the boost rail 116. When a voltage on the boost rail increases rapidly, the trigger circuit 118 may detect an ESD event in response to the slope or rate of change of the voltage over time. Since an ESD event may be characterized by a very rapid increase in the voltage and since the operating voltages do not change as rapidly, the ESD event may be readily detected based on the rate of change of the voltage level, which may cause the trigger circuit 118 to apply a gate voltage to the control terminal 120 of the MOS transistor device 122 to shunt current between from the ESD rail 110 to second supply voltage terminal 104.

When the clamp 126 is inactive, leakage current through the clamp 126 is limited by the reduced voltage on the ESD rail 110 (relative to the supply voltage $V_{DD}$ at terminal 102). Thus, overall current consumption of the circuit 100 is reduced relative to ESD protection circuits that do not include a boost rail 116 and an ESD rail 110, which have voltages that are less than but related to the supply voltage $V_{DD}$ at terminal 102. In low-power devices, it is important to limit the leakage currents. As the gate-oxide thicknesses become thinner and thinner in nanoscale CMOS transistors, the gate-tunneling leakage and other subthreshold currents in large MOS devices of an ESD protection circuit may exhibit relatively large leakage current and undesired power consumption. By reducing the voltage across the clamp device 126, such as the transistor 122, the current through the clamp device 126 may be reduced.

The boost rail 116 connects to the trigger circuit 118 and drives the gate of the clamp device 126, while the ESD rail 110 connects to the clamp device 126, which is configured to shunt current from the ESD rail 110 to the supply voltage terminal 104 in response to a signal from the trigger circuit 118. In the illustrated embodiment, the voltage drop across the metal tracks of the ESD rail 110 is not present for the boost rail 116, such that the control terminal 120 of the claim device 126 can be pulled up higher, increasing the capability to shunt current.

In the illustrated example, the voltage drop elements 112(1), 112(2), and 112(3) are coupled to the same supply voltage terminal 102. In one or more other embodiments, the voltage drop element 112(3) may be coupled between one or more supply voltage terminals that may be at different voltage levels, and the voltage drop elements 112(1) and 112(2) may be coupled to the same supply terminals, one or more different supply terminals, or any combination thereof. In one or more embodiments, the voltage drop elements 112 may have the same configuration or different configurations.

In the illustrated embodiment, a single voltage drop element 112(3) is coupled between the supply voltage terminal 102 and the boost rail 116 while two voltage drop elements 112(1) and 112(2) are coupled in series between the supply voltage terminal 102 and the ESD rail 110. In one or more embodiments, a single voltage drop element 112 having a first configuration may be coupled between the supply voltage terminal 102 and the boost rail 116 and a single voltage drop element 112 having a second configuration may be coupled between the supply voltage terminal 102 and the ESD rail 110. In one or more other embodiments, any number of voltage drop elements 112 may be coupled between the supply voltage terminal 102 and the boost rail 116 and between the supply voltage terminal 102 and the ESD rail 110. In one or more embodiments, a first voltage at the boost rail 116 may be greater than a second voltage at the ESD rail 110.

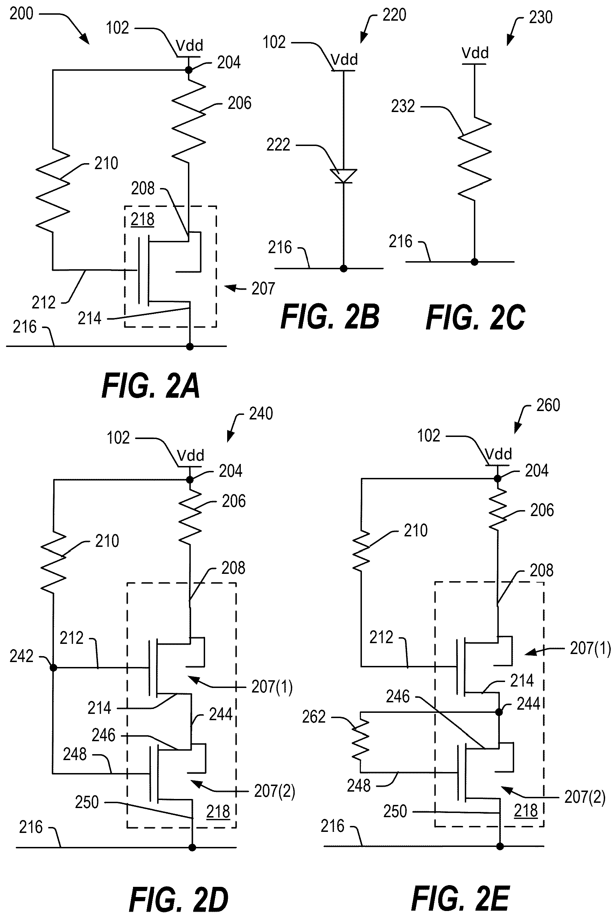

The voltage drop element 112 may be implemented by various circuits and combinations of circuits including, but not limited to a diode circuit, a resistor circuit, a transistor circuit including one or more resistors, or any combination thereof. Illustrative, nonlimiting examples of circuits that may serve as voltage drop elements 112 are described below with respect to FIGs. 2A-3C.

FIG. 2A depicts a circuit diagram of a transistor-based voltage drop element 200 that may be used in the circuit 100 of FIG. 1 to provide a voltage drop between the supply voltage $V_{DD}$ at terminal 102 and one or more of the boost rail 116 and the ESD rail 110, in accordance with certain embodiments. The element 200 may include a resistor 206 including a first terminal coupled to a node 204, which is coupled to the supply voltage $V_{DD}$ at terminal 102, and a second terminal. The element 200 may include a transistor 207 including a first terminal 208 coupled to the second terminal of the resistor 206, a control terminal (gate) 212, and a second terminal 214 coupled to a rail 216. The rail 216 may be an embodiment of the ESD rail 110 or the boost rail 116. The element 200 may further include a resistor 210 including first terminal coupled to the node 204 and a second terminal coupled to the control terminal 212 of the transistor 207.

In one or more embodiments, the transistor 207 may be implemented as a NMOS device having a deep N-well, indicated by the dashed-line rectangle 218. The deep N-well 218 may represent an isolated region of the substrate that has deep N-type doping within a P-type substrate. The deep N-well 218 may be a deep and heavily doped N-type region. The deep N-well 218 may be an N-well layer that is implanted deeper down into the substrate than a normal N-well and may be used to control substrate leakage of NMOS devices to provide better isolation. The deep N-well 218 may decrease noise coupling through it to the substrate of the semiconductor device, providing a fully-isolated NMOS device. In one or more alternative embodiments, the transistor 207 may be implemented as a PMOS device, and the resistor 210 may be coupled between the control terminal 212 and the second terminal 214 of the transistor 207.

In this example, when the transistor 207 is implemented as an NMOS device, the transistor 207 may operate in a subthreshold regime, which allows the voltage to be pulled-up relatively high. An example of a diode-based voltage drop element is described below with respect to FIG. 2B.

FIG. 2B depicts a circuit diagram of a diode-based voltage drop element 220 that may be used in the circuit of FIG. 1, in accordance with certain embodiments. The element 220 includes a diode 222 including an anode coupled to the supply voltage $V_{DD}$ at terminal 102 and a cathode coupled to the rail 216. The rail 216 may be an embodiment of the ESD rail 110 or the boost rail 116. The diode 222 may present a voltage drop that corresponds to a threshold voltage of the diode 222 such that the rail 216 is one threshold voltage lower than the supply voltage $V_{DD}$ at terminal 102. The threshold voltage of the diode 222 is a function of the process used to produce the diode 222. While the example of FIG. 2B depicts a single diode, in one or more embodiments, the diode-based voltage drop element 220 may be comprised of multiple diodes 222 arranged in series between the supply voltage germinal 102 and the rail 216.

FIG. 2C depicts a circuit diagram of a resistor-based voltage drop element 230 that may be used in the circuit of FIG. 1, in accordance with certain embodiments. The element 230 may include a resistor 232 including a first terminal coupled to the supply voltage $V_{DD}$ at terminal 102 and a second terminal coupled to the rail 216. In this example, the voltage drop across the resistor 232, as is well known in the art, is a function of the size of the resistor 232 and the amount of current flowing through the resistor 232. While FIG. 2C depicts a single resistor 232, it should be appreciated that one or more resistors 232 may be arranged in series to provide an effective resistance between the supply voltage terminal 102 and the rail 216.

FIG. 2D depicts a circuit diagram of a transistor-based voltage drop element 240 including two transistors 207(1) and 207(2) in series with a shared deep n-well 218 and with a common gate voltage that may be used in the circuit 100 of FIG. 1, in accordance with certain embodiments. In this example, the element 240 has all the components of the element 200 of FIG. 2A, except that the second terminal 214 of the transistor 207 is not connected to the rail 216.

The element 240 may include a first transistor 207(1) and a second transistor 207(2), which are arranged in series and which share the deep N-well 218. In the illustrated example, the element 240 may include the resistor 206 coupled between the node 204 and a first terminal 208 of a first transistor 207(1). The first transistor 207(1) may include the control terminal 212 coupled to a node 242. The element 240 may include the resistor 210 including a first terminal coupled to the node 204 and a second terminal coupled to the node 242. The first transistor 207 may include a second terminal 214 that is coupled to a node 244. The element 240 may include a second transistor 207(2) including a first terminal 246 coupled to the node 244, a control terminal coupled to the node 242, and a second terminal 250 coupled to the rail 216.

In this example, the transistors 207(1) and 207(2) are connected in series and share both a common deep N-well 218 and a common control terminal 212 and 248 via the node 242 and. In this example, the gate voltage at the node 242 controls both the first transistor 207(1) and the second transistor 207(2). In one or more other embodiments, the gate voltages at the control terminals 212 and 248 that control the transistors 207(1) and 207(2), respectively, may be different. An illustrative example of an embodiment of a voltage drop element including two transistors having different gate voltages is described below with respect to FIG. 2E.

FIG. 2E depicts a circuit diagram of a transistor-based voltage drop element 260 including two transistors 207(1) and 207(2) in series with a shared deep n-well 218 that may be used in the circuit of FIG. 1, in accordance with certain embodiments. The element 260 may include all the components of the element 240 in FIG. 2D except that the voltage at the control terminal 248 is different from that at the control terminal 212.

In the illustrated example, the element 260 may include a resistor 262 including a first terminal coupled to the control terminal 248 and a second terminal coupled to the first terminal 246 of the transistor 207(2). In this example, a first voltage at the control terminal 212 may be greater than a second voltage at the control terminal 248, and the first transistor 207(1) may be activated for more current flow than the second transistor 207(2).

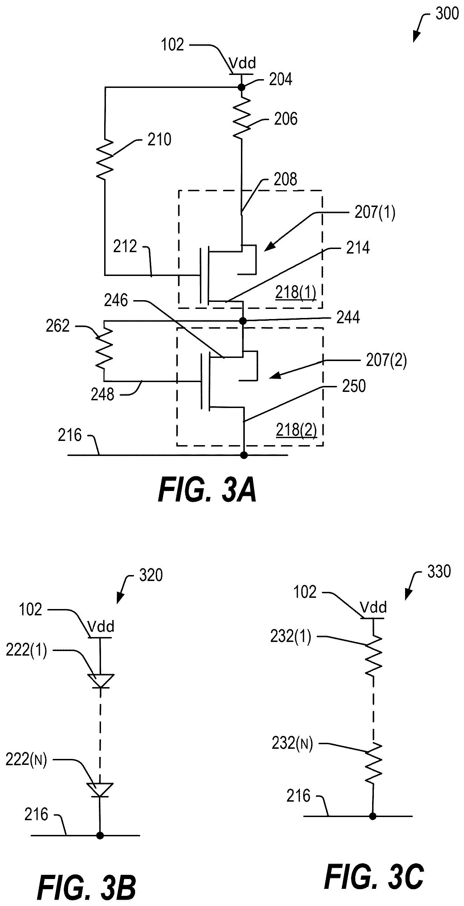

While the examples in FIGs. 2D and 2E included transistors 207 that shared a common deep N-well 218, in other embodiments, the transistors 207(1) and 207(2) may be formed in separate deep N-wells 208. An illustrative example of a voltage drop element including two transistors that are formed in separate deep N-wells 218 is described below with respect to FIG. 3A.

FIG. 3A depicts a circuit diagram of a transistor-based voltage drop element 300 including two transistors 207(1) and 207(2) in series with separate deep n-wells 218(1) and 218(2) that may be used in the circuit 100 of FIG. 1, in accordance with certain embodiments. In the illustrated example, the element 300 includes all the components of the element 260 in FIG. 2E, except that the transistor 207(1) is formed in a first deep N-well 218(1) and the second transistor 207(2) is formed in a second deep N-well 218(2).

In this example, the deep n-wells 218(1) and 218(2) may provide enhanced isolation between the transistors 207(1) and 207(2) and the underlying substrate and between the transistors 207(1) and 207(2). While the examples provided above depict two transistors 207, the transistor-based voltage drop element 240, 260, or 300 may include any number of transistors 207. In one or more embodiments, the transistor-based voltage drop element 240, 260 or 300 may include two or more transistors 207 arranged in series.

In the examples of FIGs. 2B and 2C, a single diode and a single transistor are depicted as part of the voltage drop elements 220 and 230, respectively. In one or more embodiments, the voltage drop elements may be provided with one or more circuit devices. An example of a diode-based voltage drop element including two or more diodes is described below with respect to FIG. 3B.

FIG. 3B depicts a circuit diagram of a diode-based voltage drop element 320 including multiple diodes 222 in series that may be used in the circuit of FIG. 1, in accordance with certain embodiments. The element 320 may include a number N of diodes 222(1), ..., 222(N) arranged in series between the supply voltage $V_{DD}$ at terminal 102 and the rail 216. Each diode 222 provides a voltage drop corresponding to its threshold.

FIG. 3C depicts a circuit diagram of a resistor-based voltage drop element 330 including multiple resistors 232 in series that may be used in the circuit of FIG. 1, in accordance with certain embodiments. The element 330 may include a number N of resistors 232(1), ..., 232(N) arranged in series between the supply voltage $V_{DD}$ at terminal 102 and the rail 216. The voltage drop across each resistor 232 is related to the current flow across the resistors 232.

The illustrated embodiments depicted in FIGS. 2A-3C are provided for illustrative purposes and are not intended to be limiting. The voltage drop elements of FIGs. 2A-3C are not mutually exclusive and may be combined with one or more other voltage drop elements to provide a selected voltage difference between the supply voltage $V_{DD}$ at terminal 102, the boost rail 116, and the ESD rail 110.

In one or more embodiments, the same or different voltage drop elements may be used to produce a first voltage on the boost rail 116 and a second voltage on the ESD rail 110, where the first voltage is greater than the second voltage. Various combinations of the voltage drop elements may be used to provide a selected voltage differential between the boost rail 116 and the ESD rail 110. An example of an embodiment of a circuit including the boost rail 116, the ESD rail 110, and bias circuitry configured to produce a voltage differential between the supply voltage $V_{DD}$ at terminal 102, the boost rail 116, and the ESD rail.

FIG. 4 depicts a partial block and partial circuit diagram of a circuit 400 including a low-leakage ESD protection circuit using a boost rail and an ESD rail having a voltage related to a supply voltage, in accordance with certain embodiments. The circuit 400 may include a supply voltage $V_{DD}$ at terminal 102 that is coupled to the boost rail 116 through a first voltage drop element 200. The ESD rail 110 is coupled to the boost rail 116 by one or more voltage drop elements 402.

The circuit 400 may include the I/O terminal 106. The circuit 400 may include a diode 114 including an anode coupled to the I/O terminal 106 and a cathode coupled to the boost rail 116. The circuit 400 may include a diode 108 including an anode coupled to the I/O terminal 106 and a cathode coupled to the ESD rail 110. The I/O terminal 106 may be coupled to a first input of functional circuitry 124, which may include a first supply terminal coupled to the power supply $V_{DD}$ at terminal 102 or another supply voltage, a second supply terminal coupled to the second supply voltage terminal 104, and a third input coupled to a second I/O terminal 416. The functional circuitry 124 may include processing logic or other circuitry configured to receive signals from the I/O terminals 106 and 416 and to perform one or more operations on the received signals.

The circuit 400 may include a diode 420 including an anode coupled to the I/O terminal 416 and a cathode coupled to the boost rail 116. The circuit 400 may include a diode 422 including an anode coupled to the I/O terminal 416 and a cathode coupled to the ESD rail 110. The circuit 400 may include a trigger circuit 118 including a first terminal coupled to the boost rail 116, a second terminal coupled to the second supply voltage terminal 104, and a third terminal coupled to a control terminal 120 of a transistor 122, which may have a first terminal coupled to the ESD rail 110 and a second terminal coupled to the second supply voltage terminal 104.

The first voltage drop element 200 may be a transistor-based voltage drop element including a resistor 206 coupled between the supply voltage $V_{DD}$ at terminal 102 (via the node 204) and a first terminal 208 of a transistor 207. The transistor 207 may include a second terminal 214 coupled to the boost rail 116, and a control terminal 212 coupled to the node 204 through a resistor 210. The transistor 207 may be formed in an area of the semiconductor substrate including a deep N-well 218. The first voltage drop element 200 may be configured to establish a voltage level at the boost rail 116 that is less than the supply voltage $V_{DD}$ at terminal 102.

It should be appreciated that the voltage drop element 200 is an embodiment of the voltage drop element 200 of FIG. 2A. However, in other embodiments, one or more of the voltage drop elements described with respect to FIGs. 2A-3C may be used, alone or in combination. In one or more embodiments, a second voltage drop element 402 (e.g., any of the voltage drop elements from FIGs. 2A-3C or any combination thereof) may be coupled between the boost rail 116 and the ESD rail 110 to provide a selected voltage differential.

In one or more embodiments, the second voltage drop element 402 may have the same configuration as the voltage drop element 200. In one or more embodiments, the second voltage drop element 402 may include one or more resistors and one or more diodes arranged in series between the boost rail 116 and the ESD rail 110. Other combinations of the voltage drop elements are also possible to provide the selected voltage difference between the boost rail 116 and the ESD rail 110.

In one or more embodiments, in response to an ESD event at one or more of the I/O terminals 106 or 416, the voltage on the boost rail 116 may increase rapidly, which may cause the trigger circuit 118 to activate the transistor 122, shunting the current on the ESD rail 110 to the second supply voltage terminal 104. In this example, the rate of change of the voltage with respect to time ($\frac{dV}{dt}$) may cause the trigger circuit 118 to activate the transistor 122. In one or more embodiments, the trigger circuit 118 may determine an ESD event when the rate of change of the voltage on the boost rail 116 exceeds a threshold rate of change. Otherwise, when no ESD event is present, the reduced voltage on the ESD rail 110 may yield a reduced leakage current.

FIG. 5 depicts a partial block and partial circuit diagram of a second embodiment of circuit 500 including a low-leakage ESD protection circuit using a boost rail 116 and an ESD rail 110 having a voltage related to a supply voltage $V_{DD}$. The circuit 500 is an embodiment that includes first and second I/O terminals 504 and 508 to receive first and second signals. The circuit 500 may include a first supply terminal 502 configured to receive a supply voltage $V_{DD}$. In the illustrated embodiment, the functional circuitry 124 may be coupled to the I/O terminals 504 and 508 to receive the first and second signals.

The first supply terminal 502 may be coupled to the boost rail 116 through a transistor-based voltage drop element 200. The element 200 may include a node 204 coupled to the first supply terminal 502. The element 200 may include a resistor 206 including a first terminal coupled to the node 204 and a second terminal. The element 200 may include a transistor 207 that includes a first terminal coupled to the second terminal of the resistor 206, a control terminal 212, and a second terminal 214 coupled to the boost rail 116. The element 200 may include a resistor 210 coupled between the node 204 and the node 212.

The I/O terminal 504 may be coupled to an anode of a diode 506, which has a cathode coupled to the boost rail 116. The I/O terminal 504 may be coupled to the second supply voltage terminal 104 through a first ESD circuit 512(1), which may include a diode 514(1) in series with a diode 516(1). The diode 516(1) may include an anode coupled to the second supply voltage terminal 104 and may include a cathode. The diode 514(1) may include an anode coupled to the cathode of the diode 516(1) and may include a cathode coupled to the I/O terminal 504.

The third contact pad 508 may be coupled to the anode of a diode 510, which may have a cathode coupled to the boost rail 116. The third contact pad 506 may be coupled to the second supply voltage terminal 104 through a second ESD circuit 512(2) which may include a diode 514(2) in series with a diode 516(2). The diode 516(2) may include an anode coupled to the second supply voltage terminal 104 and may include a cathode. The diode 514(2) may include an anode coupled to the cathode of the diode 516(2) and may include a cathode coupled to the second contact pad.

The circuit 500 may include a second voltage drop element, diode 518, coupled between the boost rail 116 and the ESD rail 110. The diode 518 may include an anode coupled to the boost rail 116 and a cathode coupled to the ESD rail 110.

The circuit 500 may include a transistor 122 including a first terminal coupled to the ESD rail 110, a control terminal 120, and a second terminal coupled to the second supply voltage terminal 104. The circuit 500 may include a trigger circuit 118 including a first terminal coupled to the boost rail 116, an output coupled to the control terminal 120 of the transistor 122, and a second terminal coupled to the second supply voltage terminal 104.

In the illustrated example, if the threshold voltage of the diode 518 is 0.5 volts, then the voltage on the ESD rail 110 is 0.6 volts less than the voltage on the boost rail 116, which has a voltage that is less than the supply voltage $V_{DD}$ at the first supply terminal 502. In one or more embodiments, the supply voltage at the first supply terminal 502 may be 1.2 volts, a first voltage on the boost rail 116 may be 0.9 volts, and a second voltage on the ESD rail 110 may be 0.4 volts. In one or more embodiments, the supply voltage at the first supply terminal 502 may be 1.8 volts, a first voltage on the boost rail 116 may be 1.5 volts, and a second voltage on the ESD rail 110 may be 0.9 volts. In either of such embodiments, the leakage through the transistors 122 is strongly reduced relative to conventional circuit configurations.

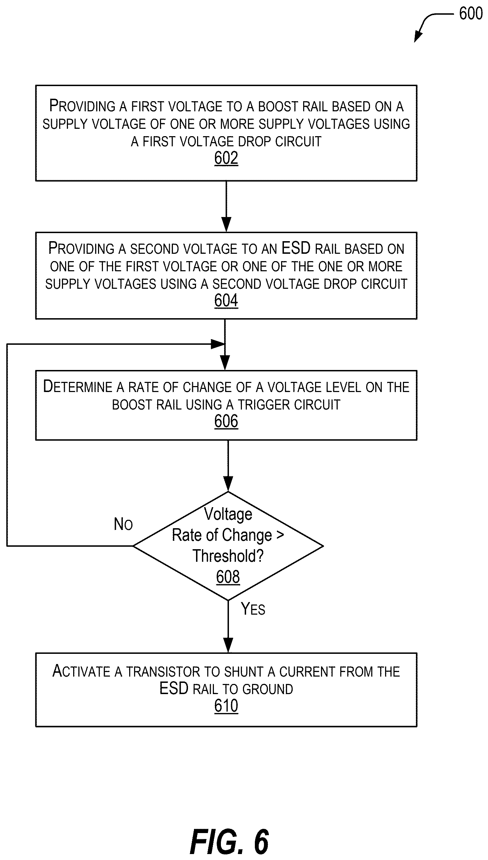

FIG. 6 depicts a method 600 of providing ESD protection using a low-leakage ESD protection circuit with a boost rail 116 and an ESD rail 110, in accordance with certain embodiments. The method 600 may be performed with any of the circuits described above with respect to FIGs. 1, 4 or 5.

At 602, the method 600 may include providing a first voltage to a boost rail 116 based on a supply voltage $V_{DD}$ of one or more supply voltages using a first voltage drop circuit. In one or more embodiments, a voltage drop circuit may be coupled between the first supply voltage VDD and the boost rail 116. The circuit may include multiple supply voltages having the same or different voltage levels. The voltage drop circuit may include any of the circuits of FIGs. 2A-3C, other circuits, or any combination thereof.

At 604, the method 600 may include providing a second voltage to an ESD rail 110 based on one of the first voltage or one of the one or more supply voltages using a second voltage drop circuit. In one or more embodiments, the second voltage drop circuit may be coupled to a selected one of the one or more supply voltages or to the boost rail 116. The second voltage on the ESD rail 110 may be less than the first voltage on the boost rail 116. The second voltage drop circuit may include any of the circuits of FIGs. 2A-3C, other circuits, or any combination thereof.

At 606, the method 600 may include determining a rate of change of a voltage level on the boost rail 116 using a trigger circuit 118. The trigger circuit 118 may include a first terminal coupled to the boost rail 116, a second terminal coupled to the second supply voltage terminal 104, and a third terminal coupled to a control terminal 122 of a transistor 120. The transistor 120 may include a first terminal coupled to the ESD rail 110, the control terminal 122, and a second terminal coupled to the second supply voltage terminal 104. In one or more embodiments, the trigger circuit 118 may be configured to compare the rate of change of the voltage on the boost rail 116 to a threshold rate of change. In one or more embodiments, the trigger circuit 118 may be a resistive-capacitive (RC) trigger circuit that may be configured to detect a rate of change. In one or more embodiments, the trigger circuit 118 may include a direct current (DC) voltage level triggered component, which may activate in response to a change in the voltage on the boost rail 116 that exceeds a threshold. In one or more embodiments, a combination of trigger components may be included within the trigger circuit 118.

At 608, if the rate of change of the voltage level on the boost rail 116 does not exceed a threshold rate of change, the method 600 may return to 606 to determine the rate of change of the voltage level on the boost rail 116. The threshold voltage rate of change may represent a slope that is greater than the slope of a non-ESD event change or fluctuation in the supply voltage $V_{DD}$ so that the trigger circuit 118 is responsive to an ESD event or other transient discharge event but is not activated by small power fluctuations. Otherwise, at 608, if the rate of change of the voltage level is greater than the threshold rate of change, the method 600 may include activating a transistor to shunt a current from the ESD rail to ground, at 610.

In conjunction with the circuits and methods described above with respect to FIGs. 1-6, embodiments of a circuit are disclosed that include ESD protection circuitry coupled to a boost rail 116, an ESD rail 110, and ground. The boost rail 116 and the ESD rail 110 may have different voltage potentials, which may vary relative to a supply voltage or to one another due to leakage currents. In one or more embodiments, the ESD rail 110 may be configured to be at a lower voltage potential than the boost rail 116. A trigger circuit 118 may be coupled between the boost rail 116 and ground, and a transistor 120 may include a first terminal coupled to the ESD rail 110, a second terminal coupled to ground, and a control terminal 122 coupled to the trigger circuit 118. In response to a voltage that exceeds a threshold or in response to a rate of change of the voltage exceeding a threshold slope, the trigger circuit 118 may activate the transistor 120 to shunt current from the ESD rail 110 to ground. During normal operation, the lower voltage on the ESD rail 110 produces a lower leakage current.

In one or more embodiments, circuits and methods are disclosed that include a boost rail 116 having a first voltage and an electrostatic discharge (ESD) rail 110 having a second voltage that is less than the first voltage. The first voltage and the second voltage may vary relative to one or more of a supply voltage at a power supply terminal or to one another due to leakage currents. An ESD protection circuit may be configured to determine an ESD event on the boost rail and to selectively shunt current from the ESD rail to one of ground or a second power supply terminal in response to determining the ESD event. The second voltage is less than the first voltage and provides a reduced leakage current though a transistor of the ESD protection circuit.

In one or more embodiments, circuits and methods are disclosed that include a boost rail having a first voltage and an electrostatic discharge (ESD) rail having a second voltage that is less than the first voltage. An ESD protection circuit may include a trigger circuit configured to determine an ESD event on the boost rail and to selectively activate a clamp circuit to shunt current from the ESD rail to a power supply terminal in response to the ESD event. The circuit may include a first voltage drop circuit having a first configuration and coupled between a first power supply terminal and the boost rail to provide the first voltage and a second voltage drop circuit having a second configuration and coupled between the ESD rail and one of the boost rail or the first power supply terminal.

Embodiments of the circuits and methods may be further understood in view of the following Examples.

Example 1: A circuit may include a boost rail; an electrostatic discharge (ESD) rail; a first voltage drop circuit coupled between a first supply voltage terminal and the boost rail to provide a first voltage at the boost rail; a second voltage drop circuit coupled between the ESD rail and one of a group consisting of the boost rail and the first supply voltage terminal to provide a second voltage at the ESD rail that is less than the first voltage; a trigger circuit including a first trigger terminal coupled to the boost rail, a second trigger terminal coupled to a second supply voltage terminal, and a third trigger terminal; and a clamp device including a first terminal coupled to the ESD rail, a second terminal coupled to the second supply voltage terminal, and a control terminal coupled to the third trigger terminal; where, in response to determining an ESD event at the Boost rail, the trigger circuit activates the clamp device to shunt current from the ESD rail to the second supply voltage terminal

Example 2: The circuit of Example 1, where the first voltage varies relative to the supply voltage due to a first leakage current; and the second voltage varies relative to one or more of the first voltage due to a second leakage current.

Example 3: The circuit of any of Examples 1-2, where the circuit further includes a first input/output (I/O) terminal configured to receive a first signal; a first diode including a first anode coupled to the first contact pad and a first cathode coupled to the ESD rail; and a second diode including a second anode coupled to the first contact pad and a second cathode coupled to the boost rail.

Example 4: The circuit of Example 3, further including a second I/O terminal configured to receive a second signal; a third diode including a first anode a third anode coupled to the second I/O terminal and a third cathode coupled to the ESD rail; and a fourth diode including a second anode coupled to the second I/O terminal and a fourth cathode coupled to the boost rail.

Example 5: The circuit of any of Examples 1-4, where the first voltage drop circuit includes at least one of a group consisting of a first transistor, a first resistor, and a first diode; and the second voltage drop circuit includes at least one of a second group consisting of a second transistor, a second resistor, and a second diode.

Example 6: The circuit of any of Examples 1-5, where the first voltage drop circuit has a first configuration; and the second voltage drop circuit has a second configuration that is different from the first configuration.

Example 7: The circuit of any of Examples 1-6, where the first voltage drop circuit includes a first resistor including a first resistor including a first terminal coupled to the supply voltage terminal and including a second terminal; a second resistor including a third terminal coupled to the supply voltage terminal and including a fourth terminal; a first transistor including a first transistor terminal coupled to the second terminal, a second transistor terminal, and a first transistor control terminal coupled to the fourth terminal; and a second transistor including a third transistor terminal coupled to the second transistor terminal, a fourth transistor terminal coupled to the boost rail, and a second transistor control terminal coupled to one of the second transistor terminal or the fourth terminal..

Example 8: The circuit of Example 7, where the first transistor and the second transistor are formed in a shared deep N-well of the circuit substrate.

Example 9: The circuit of Example 7, where the first transistor is formed in a first deep N-well of the circuit substrate and the second transistor is formed in a second deep N-well of the circuit substrate.

Example 10: The circuit of any of Examples 1-9, where the first voltage drop circuit includes a first resistor including a first terminal coupled to the supply voltage terminal and including a second terminal; a transistor including a first transistor terminal coupled to the second terminal of the first resistor, a second transistor terminal coupled to the boost rail, and a control terminal; and a second resistor including a third terminal coupled to the supply voltage terminal and including a fourth terminal coupled to the control terminal of the transistor.

Example 11: The circuit of any of Examples 1-10, where the second voltage drop circuit includes a third resistor including a fifth terminal coupled to the supply voltage terminal and including a sixth terminal; a second transistor including a third transistor terminal coupled to the sixth terminal, a fourth transistor terminal, and a second control terminal; a fourth resistor including a seventh terminal coupled to the boost rail and including an eighth terminal coupled to the second control terminal; and a third transistor including a fifth transistor terminal coupled to the fourth transistor terminal, a sixth transistor terminal coupled to the ESD rail, and a third control terminal coupled to one of the sixth terminal of the third resistor or the fourth transistor terminal.

Example 12: The circuit of Example 11, further including a fifth resistor including a first terminal coupled to the fourth transistor terminal and a second terminal coupled to the third control terminal.

Example 13: The circuit of any of Examples 1-12, where the second voltage drop circuit includes at least one of a group consisting of a diode, a resistor, and a transistor coupled between the boost rail and the ESD rail.

Example 14: A method of providing electrostatic discharge (ESD) protection includes biasing a boost rail at a first voltage that is less than a supply voltage using one or more first voltage drop circuits coupled between a power supply terminal and the boost rail; biasing an ESD rail at a second voltage that is less than the first voltage using one or more second voltage drop circuits coupled between the ESD rail and one of the boost rail or the power supply terminal; monitoring the boost rail using a trigger circuit coupled between the boost rail and a second power supply terminal; and when an ESD event is detected on the boost rail, activating, using the trigger circuit, a clamp device to shunt current from the ESD rail to the second power supply terminal.

Example 15: The method of Example 14, where the detecting an ESD event comprises determining when the rate of change of the first voltage exceeds the threshold rate of change.

Example 16: The method of any of Examples 14-15, the one or more first voltage drop circuits includes a first configuration; and the one or more second voltage drop circuits includes a second configuration that is different from the first configuration.

Example 17: A circuit may include a boost rail; an electrostatic discharge (ESD) rail; a first voltage drop circuit coupled between a first power supply terminal and the boost rail to provide a first voltage; a second voltage drop circuit coupled between the ESD rail and one of the boost rail or the first power supply terminal to provide a second voltage that is less than the first voltage; a clamp device including a first terminal coupled to the ESD rail, a second terminal coupled to a second power supply terminal, and a control terminal; and a trigger circuit coupled between the boost rail and the second power supply terminal and coupled to the control terminal of the clamp device, the trigger circuit configured to determine an ESD event at the boost rail and, in response to determining the ESD event, to selectively activate the clamp device to shunt current between the ESD rail and the second power supply terminal.

Example 18: The circuit of Example 17, where the first voltage drop circuit includes a first configuration; the second voltage drop circuit includes a second configuration; and the second configuration is different from the first configuration based on one or more of a circuit structure or a selected voltage supply source.

Example 19: The circuit of any of Examples 17 or 18, where the selected voltage supply source is selected from a group consisting of the boost rail or the first power supply terminal.

Example 20: The circuit of Example 18, where the first voltage drop circuit includes at least one of a group consisting of a first transistor, a first resistor, and a first diode; and the second voltage drop circuit includes at least one of a second group consisting of a second transistor, a second resistor, and a second diode.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

**Claims**

1. A circuit comprises:

   a boost rail (116);
   an electrostatic discharge, ESD, (110) rail;
   a first voltage drop circuit (112, 200, 220, 230, 240, 260, 300, 320, or 330) coupled between a first supply voltage terminal (102) and the boost rail (116) to provide a first voltage at the boost rail; and
   a second voltage drop circuit (112, 200, 220, 230, 240, 260, 300, 320, or 330) coupled between the ESD rail (110) and one of a group consisting of the boost rail (116) and the first supply voltage terminal (102) to provide a second voltage at the ESD rail (110) that is less than the first voltage;
   a trigger circuit (118) including a first trigger terminal coupled to the boost rail, a second trigger terminal coupled to a second supply voltage terminal (104), and a third trigger terminal (120); and
   a clamp device (126) including a first terminal coupled to the ESD rail, a second terminal coupled to the second supply voltage terminal, and a control terminal coupled to the third trigger terminal;
   wherein, in response to determining an ESD event at the boost rail, the trigger circuit activates the clamp device to shunt current from the ESD rail to the second supply voltage terminal.

2. The circuit according to claim 1, wherein:

the first voltage varies relative to the supply voltage due to a first leakage current; and the second voltage varies relative to one or more of the first voltage due to a second leakage current.

3. The circuit according to any of the preceding claims, further comprising:

a first input/output (I/O) terminal (106) configured to receive a first signal; a first diode (108) including a first anode coupled to the first contact pad and a first cathode coupled to the ESD rail (110); and a second diode (114) including a second anode coupled to the first contact pad and a second cathode coupled to the boost rail (116).

4. The circuit according to claim 3, further comprising:

a second I/O terminal (416) configured to receive a second signal; a third diode (422) including a first anode a third anode coupled to the second I/O terminal and a third cathode coupled to the ESD rail (110); and a fourth diode (420) including a second anode coupled to the second I/O terminal and a fourth cathode coupled to the boost rail (116).

5. The circuit according to any of the preceding claims, wherein:

the first voltage drop circuit includes at least one of a group consisting of a first transistor, a first resistor, and a first diode; and the second voltage drop circuit includes at least one of a second group consisting of a second transistor, a second resistor, and a second diode.

6. The circuit according to any of the preceding claims, wherein:

the first voltage drop circuit has a first configuration; and the second voltage drop circuit has a second configuration that is different from the first configuration.

7. The circuit according to any of the preceding claims, wherein the first voltage drop circuit comprises:

a first resistor (206) including a first terminal coupled to the supply voltage terminal (102) and including a second terminal; a second resistor (210) including a third terminal coupled to the supply voltage terminal and including a fourth terminal; a first transistor (208) including a first transistor terminal coupled to the second terminal, a second transistor terminal, and a first transistor control terminal coupled to the fourth terminal; and a second transistor (246) including a third transistor terminal coupled to the second transistor terminal, a fourth transistor terminal coupled to the boost rail, and a second transistor control terminal coupled to one of the second transistor terminal or the fourth terminal.

8. The circuit according to claim 7, wherein the first transistor (208) and the second transistor (246) are formed in a shared deep N-well of the circuit substrate.

9. The circuit according to claim 7, wherein the first transistor is formed in a first deep N-well of the circuit substrate and the second transistor is formed in a second deep N-well of the circuit substrate.

10. The circuit according to any of the preceding claims, wherein the first voltage drop circuit comprises:

a first resistor (206) including a first terminal coupled to the supply voltage terminal (102) and including a second terminal; a transistor (208) including a first transistor terminal coupled to the second terminal of the first resistor, a second transistor terminal coupled to the boost rail, and a control terminal; and a second resistor (210) including a third terminal coupled to the supply voltage terminal and including a fourth terminal coupled to the control terminal of the transistor.

11. The circuit according to claim 10, wherein the second voltage drop circuit comprises:

a third resistor including a fifth terminal coupled to the supply voltage terminal and including a sixth terminal; a second transistor including a third transistor terminal coupled to the sixth terminal, a fourth transistor terminal, and a second control terminal; a fourth resistor including a seventh terminal coupled to the boost rail and including an eighth terminal coupled to the second control terminal; and a third transistor including a fifth transistor terminal coupled to the fourth transistor terminal, a sixth transistor terminal coupled to the ESD rail, and a third control terminal coupled to one of the sixth terminal of the third resistor or the fourth transistor terminal.

12. The circuit according to claim 11, further comprising a fifth resistor including a ninth terminal coupled to the fourth transistor terminal and a tenth terminal coupled to the third control terminal.

13. The circuit according to any of the preceding claims, wherein the second voltage drop circuit comprises at least one of a group consisting of a diode, a resistor, and a transistor coupled between the boost rail and the ESD rail.

14. A method of providing electrostatic discharge (ESD) protection, the method comprising:

   biasing a boost rail at a first voltage that is less than a supply voltage using one or more first voltage drop circuits coupled between a power supply terminal and the boost rail;
   biasing an ESD rail at a second voltage that is less than the first voltage using one or more second voltage drop circuits coupled between the ESD rail and one of the boost rail or the power supply terminal;
   monitoring the boost rail using a trigger circuit coupled between the boost rail and a second power supply terminal;
   determining an ESD event when a rate of change of the first voltage exceeds a threshold rate of change; and
   when an ESD event is detected on the boost rail, activating, using the trigger circuit, a clamp device to shunt current from the ESD rail to the second power supply terminal.

15. The method of claim 14, wherein:

   the one or more first voltage drop circuits includes a first configuration; and
   the one or more second voltage drop circuits includes a second configuration that is different from the first configuration.

**FIG. 1**

FIG. 2A

FIG. 2B    FIG. 2C

FIG. 2D    FIG. 2E

300

102
Vdd
204
206
210
208
207(1)
212
214
218(1)
246
244
262
207(2)
248
250
216
218(2)

**FIG. 3A**

320

102
Vdd
222(1)
222(N)
216

**FIG. 3B**

330

102
Vdd
232(1)
232(N)
216

**FIG. 3C**

*FIG. 4*

**FIG. 5**

600

PROVIDING A FIRST VOLTAGE TO A BOOST RAIL BASED ON A
SUPPLY VOLTAGE OF ONE OR MORE SUPPLY VOLTAGES USING
A FIRST VOLTAGE DROP CIRCUIT
602

PROVIDING A SECOND VOLTAGE TO AN ESD RAIL BASED ON
ONE OF THE FIRST VOLTAGE OR ONE OF THE ONE OR MORE
SUPPLY VOLTAGES USING A SECOND VOLTAGE DROP CIRCUIT
604

DETERMINE A RATE OF CHANGE OF A VOLTAGE LEVEL ON THE
BOOST RAIL USING A TRIGGER CIRCUIT
606

No ← Voltage
Rate of Change >
Threshold?
608

YES

ACTIVATE A TRANSISTOR TO SHUNT A CURRENT FROM THE
ESD RAIL TO GROUND
610

*FIG. 6*

Europäisches
Patentamt

European
Patent Office

Office européen
des brevets

# EUROPEAN SEARCH REPORT

**Application Number**

EP 25 21 6413

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/109270 A1 (STOCKINGER MICHAEL [US] ET AL) 10 June 2004 (2004-06-10) | 1-6, 13-15 | INV. H10D89/60 H02H9/04 |
| A | * abstract; figure 10 * <br> * paragraphs [0060] - [0063] * <br> ----- | 7-12 | |
| X | STOCKINGER MICHAEL ET AL: "An active MOSFET rail clamp network for component and system level protection", ELECTRICAL OVERSTRESS ELECTROSTATIC DISCHARGE SYMPOSIUM PROCEEDINGS GRIFFISS, NY : CENTER, US, 10 September 2013 (2013-09-10), pages 1-10, XP032507506, ISSN: 0739-5159 [retrieved on 2013-10-16] | 1-6, 13-15 | |
| A | * the whole document * <br> ----- | 7-12 | |
| X | US 2004/027742 A1 (MILLER JAMES W [US] ET AL) 12 February 2004 (2004-02-12) | 1-6,14, 15 | |
| A | * abstract; figures 2, 3 * <br> * paragraphs [0026], [0027] * <br> ----- | 7-12 | |

**TECHNICAL FIELDS SEARCHED (IPC)**

H10D
H02H

The present search report has been drawn up for all claims

| Place of search | Date of completion of the search | Examiner |
|---|---|---|
| Berlin | 21 April 2026 | Morena, Enrico |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 21 6413

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2026

| Patent document cited in search report | | | Publication date | Patent family member(s) | | Publication date |
|---|---|---|---|---|---|---|
| US 2004109270 | A1 | | 10-06-2004 | AU | 2003265364 A1 | 30-06-2004 |
| | | | | TW | I307155 B | 01-03-2009 |
| | | | | US | 2004109270 A1 | 10-06-2004 |
| | | | | WO | 2004054063 A2 | 24-06-2004 |
| US 2004027742 | A1 | | 12-02-2004 | AU | 2003254097 A1 | 25-02-2004 |
| | | | | CN | 1628385 A | 15-06-2005 |
| | | | | EP | 1527481 A2 | 04-05-2005 |
| | | | | JP | 4322806 B2 | 02-09-2009 |
| | | | | JP | 2005536046 A | 24-11-2005 |
| | | | | KR | 20050026915 A | 16-03-2005 |
| | | | | TW | I282161 B | 01-06-2007 |
| | | | | US | 2004027742 A1 | 12-02-2004 |
| | | | | WO | 2004015776 A2 | 19-02-2004 |

EPO FORM P0459

For more details about this annex : see Official Journal of the European Patent Office, No. 12/82